# EUROPEAN PATENT SPECIFICATION

(11) **EP 1 608 007 B1**
(45) Date of publication and mention of the grant of the patent: **15.08.2012**
(21) Application number: 04721668.4
(22) Date of filing: 18.03.2004
(51) Int. Cl.: H01L 21/316, H01L 21/318, C23C 16/56, C23C 16/455, H01L 21/3105, H01L 21/314, H01L 29/51, H01L 21/28

(54) **METHOD FOR FORMING INSULATING FILM IN SEMICONDUCTOR DEVICE**
VERFAHREN ZUR BILDUNG EINES ISOLATIONSFILMS IN EINEM HALBLEITERBAUELEMENT
PROCEDE DE FORMATION DE FILM ISOLANT DANS UN DISPOSITIF SEMICONDUCTEUR

(30) Priority: 24.03.2003 JP 2003079279
(43) Date of publication of application: 21.12.2005
(73) Proprietor: HORIBA, LTD., Kyoto-shi, Kyoto 601-8510 (JP); Renesas Technology Corp., Tokyo 100-6334 (JP); ROHM CO., LTD., Kyoto-shi, Kyoto 615-8585 (JP)
(72) Inventor: TOMINAGA, Koji c/o Horiba, Ltd., Kyoto-shi, Kyoto 601-8510 (JP); YASUDA, T. Nat. Inst. of AdvancedInd. Science and, Tsukuba-shi, Ibaraki 305-8562 (JP); NABATAME, Toshihide c/o Renesas Technology Corp., Chiyoda-ku, Tokyo 100-6334 (JP); IWAMOTO, Kunihiko c/o Rohm Co., Ltd., Kyoto-shi, Kyoto 615-8585 (JP)
(74) Representative: Cross, Rupert Edward Blount
(86) International application number: PCT/JP2004/003638
(87) International publication number: WO 2004/086485

(56) References cited:
- EP-A1- 1 326 271
- WO-A1-02/23614
- WO-A1-02/099868
- JP-A- 2003 017 684
- JP-A- 2003 188 171
- JP-A- 2003 347 298
- US-A1- 2002 076 946
- US-A1- 2003 003 635
- US-B1- 6 228 781

## Description

### BACKGROUND OF THE INVENTION

### Field of the Invention

The present invention relates to a method for forming an insulating film in a semiconductor device, and particularly relates to a method for forming a gate insulating film in a MIS (Metal Insulator Semiconductor) transistor or a capacitor insulating film in a MIM (Metal Insulator Metal) capacitor.

### Description of the Related Art

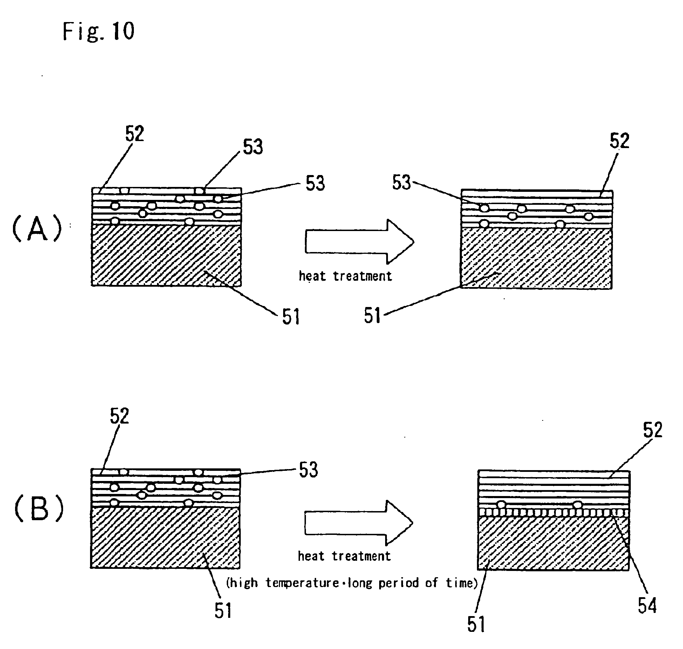

In recent years, with the increase in integration of semiconductors, metal oxides and the like (high-k films) which have a large dielectric constant have been in use for insulating films of the semiconductors. For example, Al₂O₃, HfO₂ and the like are known as the high-k films, and an ALD (Atomic Layer Deposition) method is used as a technique for forming the high-k film. In this ALD method, trimethyl aluminum [TMA: AI(CH₃)₃] and water vapor (H₂O) are for example used as precursor, and these precursor are alternately sprayed onto an Si substrate to form an Al₂O₃ film. At this time, a CH₃ group (methyl group) constituting the precursor is captured in the film and behaves as impurities (C. H, ) to cause deterioration in film quality. As a method for removing the impurities, for example in the case of a gate insulating film in a MIS transistor, typically, a high-k film 52 having been formed on the upper surface of a Si substrate 51 is heat treated, as shown on the right side of Fig. 10(A).

However, the heat treatment after the film formation as thus described is not sufficient, only removing the impurities 53 in the vicinity of the surface of the formed high-k film 52 as shown in Fig. 10(A). Therefore, in the case of treating impurities by heat treatment in a deep place in proximity to the interface between the Si substrate 51 and the high-k film 52, the heat treatment needs to be performed at high temperature or for a long period of time as shown in Fig. 10(B). However, in such a case, as shown on the right side of Fig. 10(B), an interface layer 54 comprising SiO2 or the like is undesirably formed on the interface. This interface layer 54 has a low dielectric constant ε (ε = 3.9), thereby impairing the favorable effect of the high-k film 52.

There is another impurity removing method other than the above-mentioned heat treatment, in which plasma oxidation is performed for the removal, as described in "Hitachi Kokusai Electric Inc, Extended Abstracts of 49th Spring Meeting of Japan Society of Applied Physics, 28pA-11-14". This impurity removing method comprises a step of forming HfO₂ (hafnium oxide) film by CVD (Chemical Vapor Deposition) method in combination with a step of removing impurities by plasma oxidation. However, there is a problem even with this method in that the interface layer 54 as shown in Fig. 10(B) is easily formed.

The foregoing problems have occurred not only in forming the gate insulating film of the MIS transistor, but similarly in forming a capacitor insulating film of a MIM capacitor.

US 2003-003635A discloses an ALD film forming process in which a thermal or plasma anneal of the ALD film is performed every 25 to 50 Å of film thickness.

US 2002-076946A discloses a method of forming Ta₂O₅ dielectric layer by ALD, in which each ALD cycle includes an insitu N₂O plasma treatment to remove carbon from the mono atomic layer.

### SUMMARY OF THE INVENTION

This invention was made, taking note of the foregoing matters, and has an object to provide a method for forming an insulating film in a semiconductor device (hereinafter simply referred to as an insulating film forming method), capable of preventing as many impurities as possible, which cause deterioration in film quality, from existing in an insulating film in a semiconductor device.

In order to achieve the above-mentioned object, an insulating film forming method of the present invention is characterized as set out in claim 1.

In the insulating film forming method according to claim 1, an insulating film having a required thickness is not formed in a single process, but the step of forming an insulating film so as to have a thickness in the range of 0.3 to 2 nm and the step of removing impurities from the insulating film are repeated a plurality of times to form an insulating film having a prescribed thickness. In this manner, it is possible to easily and certainly form a high-k film containing as few impurities as possible, while preventing inconvenience caused by the growth of the interface layer.

The step of removing impurities may be performed in a reducing gas atmosphere or an oxidizing gas atmosphere (claim 2), and further, the step of removing impurities may be performed in a reducing gas atmosphere combined with an oxidizing gas atmosphere (claim 3). It is possible to easily and certainly form a desired high-k film in any of the gas atmospheres.

The reducing atmosphere in the step of removing impurities can be formed of any of single gases of an ammonia gas, a hydrogen gas and an inert gas, a mixed gas of these gases or plasma nitrogen, or formed in a vacuum (claim 4).

Further, the oxidizing gas atmosphere in the step of removing impurities can be formed of any of single gases of an oxygen gas, a nitrogen monoxide gas, a nitrous oxide gas and an ozone gas, a mixed gas of these gases or plasma oxygen (claim 5).

### BRIEF DESCRIPTION OF THE DRAWINGS

Fig. 1 is a view schematically showing a configuration of a MIS transistor to which an insulating film forming method of the present invention is applied;
Fig. 2 is a view for explaining a result of thermal desorption spectroscopy of a Al₂O₃ film;
Fig. 3 is a view for explaining a result of thermal desorption spectroscopy of an HfO₂ film;
Fig. 4 is a view for explaining a result of thermal desorption spectroscopy of an HfA10. film;
Fig. 5 is a view for explaining a result of soft x-ray photoelectron spectroscopy of the HfO₂ film;
Fig. 6 is a view for explaining one example of methods for producing a semiconductor device according to the present invention;
Fig. 7 is a view showing a characteristic of a high-k film formed by the above-mentioned method for producing a semiconductor device, together with characteristics of comparative examples;
Fig. 8 is a view for explaining another example of the methods for producing a semiconductor device according to the present invention;
Fig. 9 is a view schematically showing a configuration of a MIM capacitor to which the insulating film forming method of the present invention is applied; and
Fig. 10 is a view for explaining a conventional art and disadvantages thereof.

### DETAILED DESCRIPTION OF THE PREFERRED EMBODIMENTS

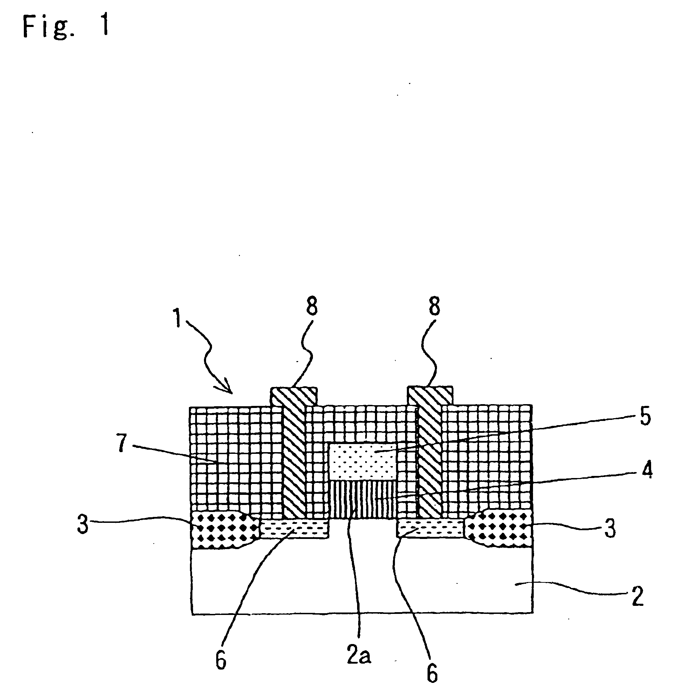

In the following, the present invention is specifically described with respect to drawings. First, Fig 1 is a view schematically showing a configuration of a MIS transistor 1 as a semiconductor device to which the insulating film forming method of the present invention is applied. In this figure, reference numeral 2 denotes a Si monocrystal substrate (hereinafter simply referred to as a Si substrate), and the resistivity thereof is from 0.01 to 15 Ω · cm, for example. Reference numeral 3 denotes an element isolation oxide film for isolating elements, which is formed by thermal oxidation of the Si substrate 2. Reference numeral 4 denotes a gate insulating film to be formed on the surface 2a of the Si substrate 2. A method for forming the gate insulating film 4 is specifically described later.

Reference numeral 5 denotes a gate electrode to be formed on the upper surface of the gate insulating film 4. For example, the gate electrode 5 is made of a noble metal such as Pt (platinum) or a high melting point metal such as TiN or TaN, the noble metal and the high melting point metal not reacting with a polycrystal Si film, a polycrystal SiGe film or the gate insulating film 4. Reference numeral 6 denotes a channel region. P (phosphorous) or the like is injected into an n channel and B (boron) or the like is injected into a p channel, and those channels are heat treated at temperatures of 800 to 1,000 °C for 10 to 30 minutes to be activated. Reference numeral 7 denotes an interlayer insulating film, which for example comprises SiO₂ or the like and is formed by CVD (Chemical Vapor Deposition) method or the like. Reference numeral 8 denotes an extraction electrode of the channel 6. The extraction electrode 8 for example comprises Al and serves as a source/drain electrode. It is to be noted that patterning is performed for example by means of the photolithography technique.

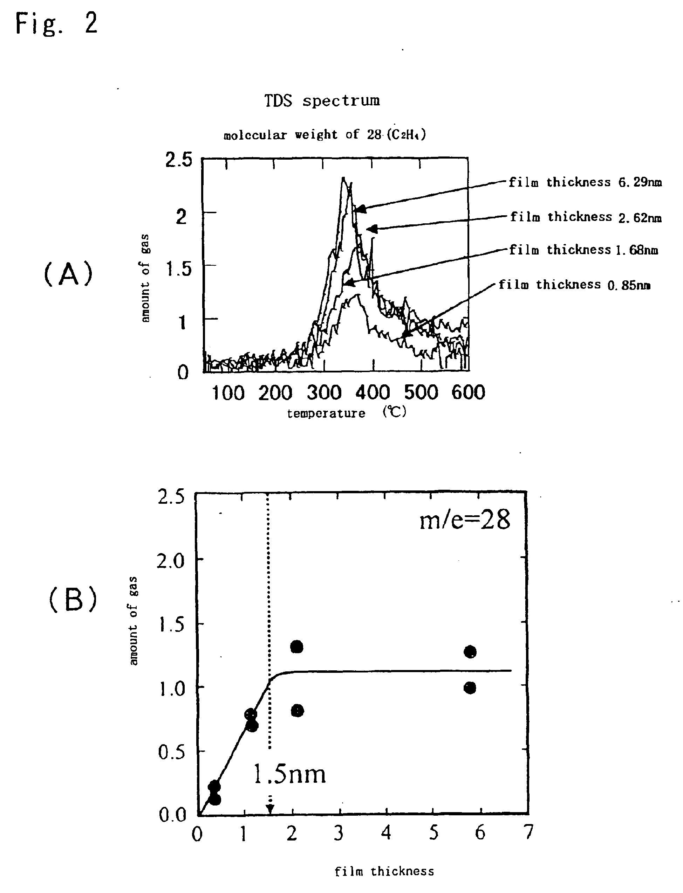

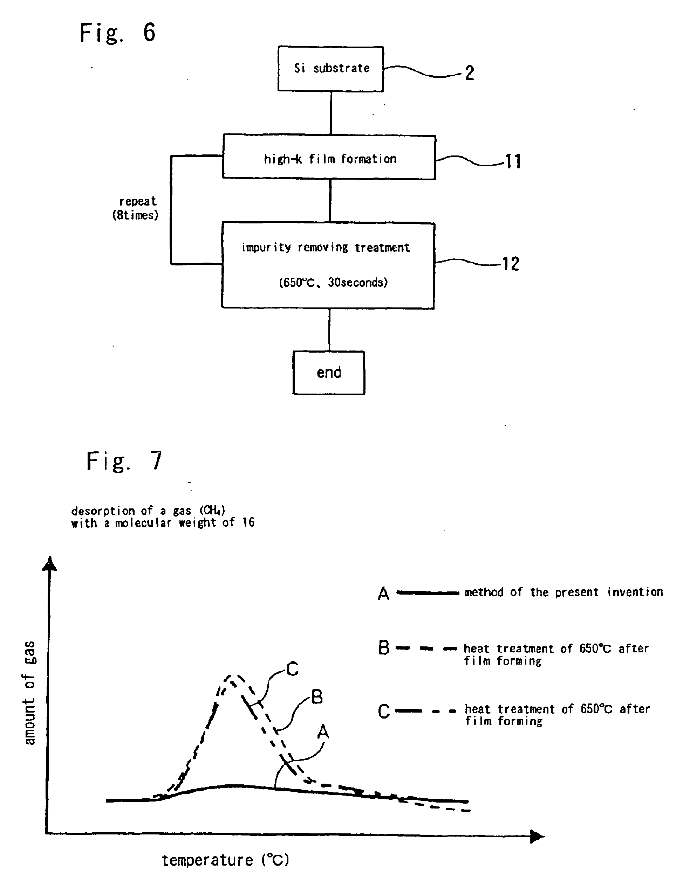

The gate insulating film 4 is made of a high-k film having a required thickness. As shown in Fig. 6, the gate insulating film 4 is characterized in that it is formed by sequentially repeating a film formation step 11 and an impurity removing step (anneal step) 12 a plurality of times. Namely, it is characterized in that, instead of forming the high-k film 4 having a required thickness on a Si substrate in a single process, a film having a prescribed thickness is formed by degrees and then annealed in an atmosphere of a prescribed gas to reduce as many residual impurities as possible. Therefore, before concrete examples of the method for forming the gate insulating film 4 are described, experiments conducted by the present inventors and consideration of the results thereof are described with reference to Figs. 2 to 5.

First, for example, on a Si substrate made of a Si monocrystal plate having an appropriate thickness (e.g. about 500 µm), an Al₂O₃ film was formed by the ALD method so as to have a thickness of 0.3 to 6.3 nm. The film was formed under conditions that a substrate temperature was 250 °C and as precursor, TMA (Al(CH₃)₃: trimethyl aluminum) was used as an Al precursor while a water vapor gas was used as an oxidant. The Al₂O₃ film was analyzed using a TDS (Thermal Desorption Spectroscopy) device. Fig. 2 shows the results of the analyses. In Fig. 2, (A) shows desorption of a C₂H₄ gas (molecular weight: 28) when the film thickness is variously changed, and (B) shows the relation between the film thickness and the amount of the C₂H₄ gas desorbed. It should be noted that results of analyses using other molecular weights, such as CH₄ with a molecular weight of 16 or C₂H₆ with a molecular weight of 30, and further, CO₂ with a molecular weight of 44, showed similar tendencies to those shown in Fig. 2.

Since TDS is a method of increasing a gas temperature and simultaneously analyzing a gas being desorbed, performing TDS can be considered as being equivalent to performing heat treatment. From the results of this analysis, it was discovered that the thickness of the film from which impurities can be removed by heat treatment is limited to about 1.5 nm or smaller, and impurities may remain in a film having a thickness exceeding this limitation.

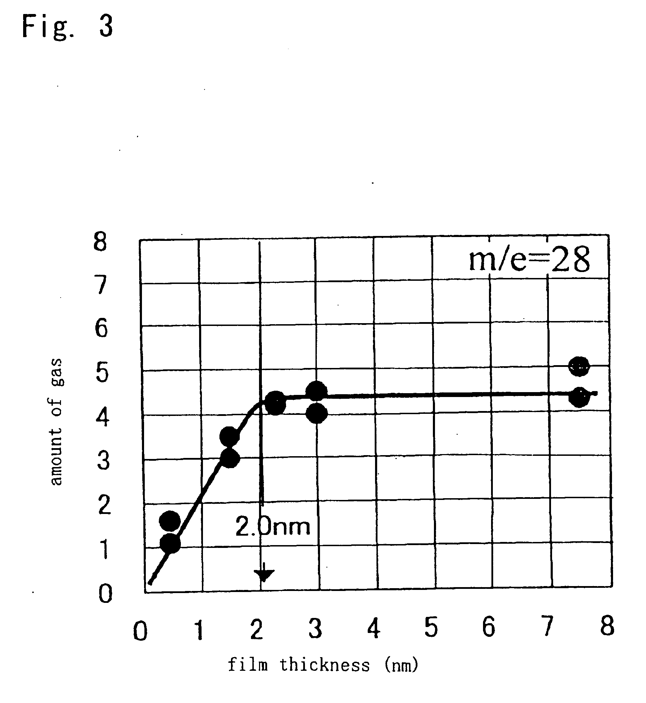

Further, for example, on a Si substrate made of a Si monocrystal plate having an appropriate thickness (e.g. about 500 µm), an HfO₂ film was formed by the ALD method so as to have a thickness of 0.7 to 7.5 nm. The film was formed under conditions that a substrate temperature was 250 °C and as the precursor, TDMAH (Hf(N(CH₃)₂)₄: tetrakis(dimethylamino) hafnium) was used as an Hf precursor while the water vapor gas was used as the oxidant. The HfO₂ film was subjected to TDS using the TDS device. Fig. 3 shows the results of the analysis. From the relation between the film thickness and the desorption of a C₂H₄ (gas molecular weight: 28) as shown in Fig. 3, it is found that the amount of the gas desorbed is saturated when the film thickness reaches or exceeds a certain value, and therefore the impurities contained in the film can be removed by making the film thickness not larger than the certain value. It is especially found from Fig. 3 that the impurities can be favorably removed so long as the film thickness is not larger than 2.0 nm. It should be noted that results of analyses using other molecular weights, such as CH₄ with a molecular weight of 16 or C₂H₆ with a molecular weight of 30, and further, CO₂ with a molecular weight of 44, showed similar tendencies to those shown in Fig. 3.

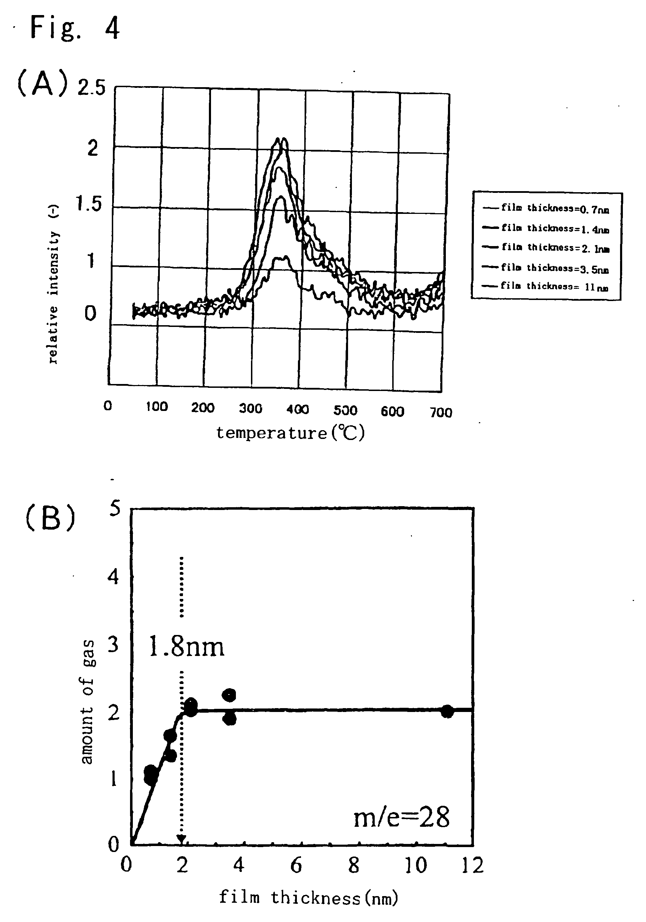

Moreover, for example, on a Si substrate made of a Si monocrystal plate having an appropriate thickness (e.g. about 500 µm), an HfAlO. film was formed by the ALD method so as to have a thickness of 0.7 to 11 nm. The film was formed under conditions that a substrate temperature was 250 °C and as the precursor, TMA was used as an Al precursor and TDMAH was used as the Hf precursor while the water vapor gas was used as the oxidant. The HfAlO. film was subjected to TDS using the TDS device. Fig. 4 shows the results of the analysis. In Fig. 4, (A) shows a TDS spectrum with a molecular weight of 28 (C₂H₄) when the film thickness is variously changed, and (B) shows the relation between the film thickness and the amount of the C₂H₄ gas desorbed.

From the results shown in Fig 4, it is found that the amount of the gas desorbed is saturated when the film thickness reaches or exceeds a certain value, and therefore the impurities contained in the film can be removed by making the film thickness not larger than the certain value. It is especially found from Fig. 4(B) that the impurities can be favorably removed so long as the film thickness is not larger than 1.8 nm.

It is then derived from the results shown in Figs. 2 to 4 that the thickness of the film from which impurities can be removed changes depending upon the kind of element to constitute the film, and that the impurities can be certainly removed by heat treatment when the film thickness is in the range of 0.3 to 2.0 nm (optimally in the range of 0.5 to 1.8 nm). It should be noted that 0.3 nm is a minimum film thickness for forming a film, and it corresponds to a thickness of one monolayer (monoatomic layer).

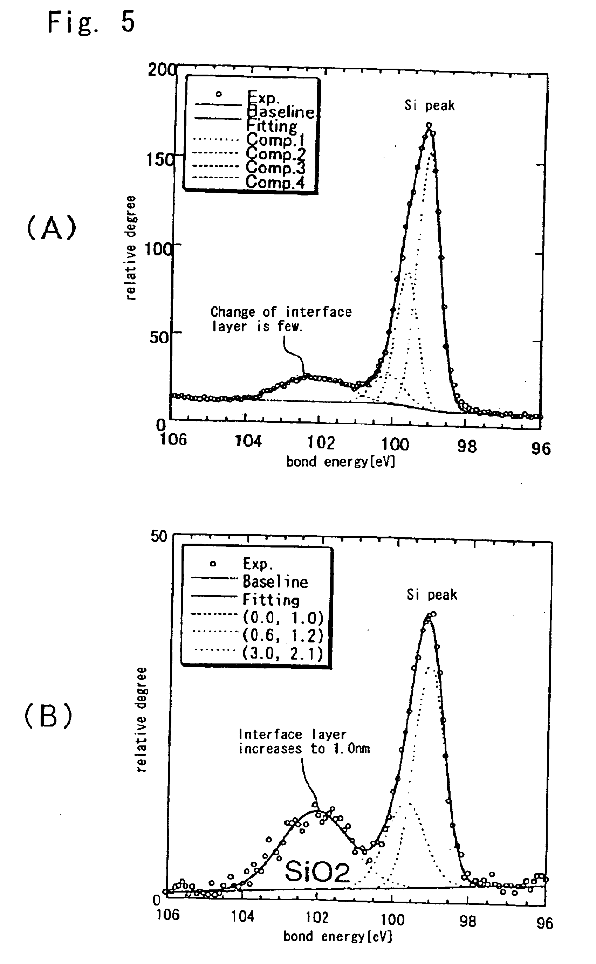

Next, the impurity removing step (anneal step) to be performed after the film forming method is described. This impurity removing step (anneal step) is to anneal a high-k film in an atmosphere of a certain gas in a prescribed temperature condition. As the atmosphere gas, a reducing gas atmosphere or an oxidizing gas atmosphere can be employed. After the film forming step, the impurity removing step (anneal step) is performed in the reducing gas atmosphere appropriately combined with the oxidizing gas atmosphere. Fig. 5 shows data of measurement by XPS (soft X-ray Photoelectron Spectroscopy) after the impurity removing step (anneal step). Fig. 5 (A) shows the case of performing a first anneal in the reducing gas atmosphere, and (B) shows the case of performing a first anneal in the oxidizing gas atmosphere. Fig. 5 reveals that the interface layer increases in a smaller degree when the anneal is performed in the reducing gas atmosphere rather than in the oxidizing gas atmosphere. That is, appropriate control of the atmosphere gas during the anneal can suppress the formation of the interface layer.

Next described is the insulating film forming method of the present invention, and more specifically, a concrete example of the method for forming the gate insulating film 4 of the MIS transistor 1. Figs. 6 and 7 show views for explaining a first example of the present invention. In this example, a high-k film as the gate insulating film 4 has a film thickness of 4.0 nm. First, a Si substrate 2 made of a Si monocrystal plate having an appropriate thickness (e.g. about 500 µm) is prepared and on the surface thereof, an HfAlO. film, as the high-k film, having a film thickness of 0.5 nm is formed (first film formation, c.f. reference numeral 11 in Fig. 6). The film is formed under conditions that a substrate temperature is 250 °C and as precursor, TMA is used as an Al precursor and TDMAH as an Hf precursor, while a water vapor gas as an oxidant.

Subsequently, the HfAlO, film is heat treated in an NH₃ (ammonia) gas atmosphere as the reducing gas atmosphere at 650 °C for 30 seconds, to treat impurities (first heat treatment, c.f. reference numeral 12 in Fig. 6). It is preferable to perform this first heat treatment in the reducing gas atmosphere. This is because, since the film thickness becomes as thin as 0.5 nm if the heat treatment is performed in the oxidizing gas atmosphere, Si on the interface is oxidized to form SiO₂, thereby forming an interface layer having a low dielectric constant. It is to be noted that, although the heat treatment is performed at a temperature of 650°C in the present example, it is found possible from the results shown in Fig. 2(A) and Fig. 4(A) to obtain a required effect of removing impurities by previously setting the atmosphere temperature at the time of the heat treatment to about 500°C or higher. It is therefore to treat impurities for removal at a temperature of 500 °C or higher.

After the first heat treatment has performed, an HfAlO. film is formed so as to have the same thickness under the same film formation conditions as in the case of the first film formation. (second film formation, c.f. reference numeral 11 in Fig. 6).

After the second film formation has performed, heat treatment is performed in an oxygen gas atmosphere (e.g. under a pressure of 130 Pa) at the same temperature for the same period of time as in the case of first heat treatment (second heat treatment, c.f. reference numeral 12 in Fig. 6).

Thereafter, the film formation and the heat treatment are alternately repeated until the seventh film formation and the seventh heat treatment are completed. Here, the heat treatment is performed in the same manner as in the second heat treatment.

The eighth film formation is performed in the same manner as in the first to seventh film formations, whereafter the impurities are treated by heat treatment in the oxygen gas atmosphere (oxidizing gas atmosphere) at the same temperature and for the same period of time as in the case of the first to seventh heat treatments, to treat the impurities.

Fig. 7 shows the results of TDS of the following three kinds of films: an HfAlO, film A (film thickness: 4.0 nm) formed by alternately repeating the foregoing film formation and heat treatment a plurality of times; an HfAlO. film B obtained by first forming an HfAlO. film having a thickness of 4.0 nm and finally heat treating the film at 650 °C for 30 seconds for treating impurities; and an HfAlO. film C obtained by first forming an HfAlO. film having a film thickness of 4.0 nm and finally heat treating the film at 850°C for 30 seconds for treating impurities.

In Fig. 7, almost no desorption gas (CH₄ gas) is observed in the HfAlO. film A formed by alternately repeating the film formation and the heat treatment (impurity removing treatment) according to the method of the present invention. It should be noted that, although the desorption of the CH₄ gas with a molecular weight of 16 is shown in Fig. 7, other molecular weights, such as C₂H₄ with a molecular weight of 28 or C₂H₆ with a molecular weight of 30, and further, CO₂ with a molecular weight of 44, show similar results to those shown in Fig. 7.

It was also confirmed that, in the case of the HfAlO. film according to the method of the present invention, there formed no interface layer having a low dielectric constant on the interface with Si.

As thus described, the HfAlO. film (high-k film) according to the method of the present invention contains few impurities, and there is no low dielectric constant layer between the HfAlO. film and Si. Further, in the method of the present invention, since the impurities can be removed at a relatively low temperature of 650 °C , crystallization of the high-k film is favorably suppressed, thereby eliminating disadvantages of crystallization of the high-k film, i.e. once crystallized, the high-k film has a crystal grain boundary as a point of weakness, resulting in decreased reliability.

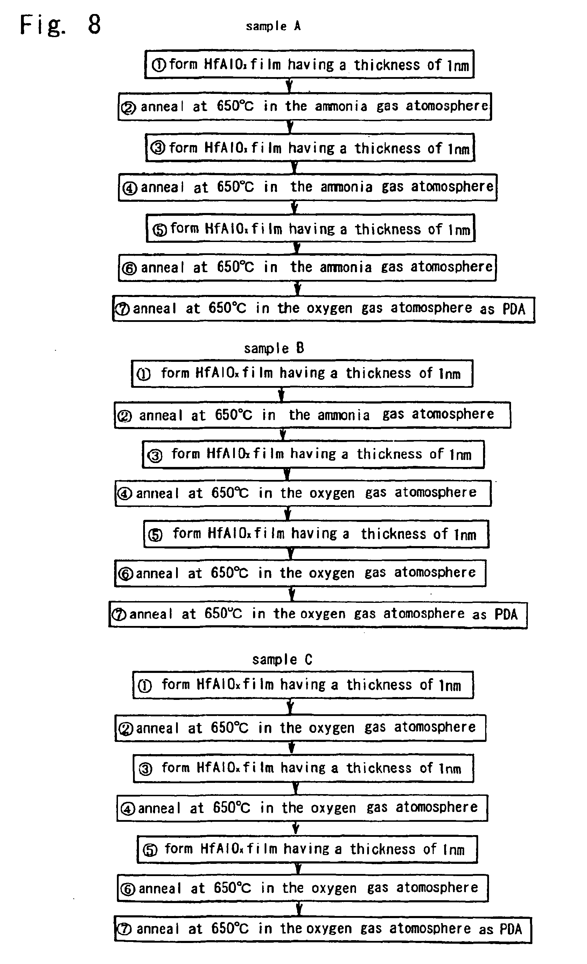

Next, Fig. 8 shows a second example of the present invention. In the second example, using the same precursor as those of the first example, an HfAlO. film having a thickness of 3 nm is formed on the Si substrate. In Fig. 8, samples A, B and C are high-k films each formed by the steps (1) to (7) where an HfAlO. film having a thickness of 1 nm is formed and then heat treated in a prescribed gas atmosphere. Further, as a comparative example, a high-k film having a thickness of 3 nm formed in a single process according to the conventional method is referred to as a sample D. Any of these samples A to D was annealed in the oxygen gas atmosphere at 650°C as heat treatment (PDA) after the film formation.

Among the samples A to C showing the high-k films according to the method of the present invention, the samples A and B are in an ammonia gas atmosphere in a first anneal (heat treatment) whereas the sample C is annealed in the oxygen gas atmosphere in the first anneal (heat treatment). Moreover, in second and third anneals, the samples A is annealed in the ammonia gas atmosphere whereas the sample B is annealed in the oxygen gas atmosphere. Meanwhile, the sample C is annealed in the oxygen gas atmosphere in the first through third anneals (heat treatments)

The physical properties of the foregoing samples A to D were evaluated. Namely, an amount of carbon as residual impurities in the film was analyzed by SIMS (Secondary Ionization Mass Spectrometer). Further, the samples were subjected to the x-ray reflectance measurement to obtain the denseness thereof. The results of the analysis and the measurement were shown in Table 1 below:

**[Table 1]**

| | amount of carbon | denseness of film(g/cm³) |
|---|---|---|
| A | 0. 15 | 8. 8 |
| B | 0. 12 | 8. 5 |
| C | 0. 11 | 8. 5 |
| D | 1. 00 | 8. 0 |

It is found from the results of Table 1 above that impurities can be removed from the samples A to C according to the method of the present invention, and that these samples are dense. Further, a sample, having been treated with plasma oxide at 200 W throughout the impurity removing step, contains carbon in an amount of 0.18, revealing that impurities are removable also by the plasma oxide treatment.

Furthermore, as the electric characteristics of each of the above-mentioned samples A to D, hysteresis (relation between an applied voltage and capacity) in a CV (Capacitance-Voltage) curve and a leak current were measured, to obtain the results as shown in Fig. 2.

**[Table 2]**

| | hysteresis in a CV (mV) | leak current (mV/cm²) |
|---|---|---|
| A | 1 5 | 7. 0 |
| B | 1 5 | 5. 0 |
| C | 1 0 | 1 . 1 |
| D | 8 0 | 1 1. 0 |

It is found from the above table 2 that, any of the samples A to C according to the method of the present invention is more excellent in electric characteristic than the sample D according to the conventional method. Namely, the smaller a hysteresis in a CV curve of a film, the lower the interface level of the film and the better quality the film has. The hysteresis of each of the samples A to C is significantly smaller than that of Sample D. Further, the leak current of each of the samples A to C is significantly smaller than that of the sample D. This is because, as apparent from Fig. 1, each of the samples A to C is a dense film of good quality having a large film density and containing a very small amount of impurities as compared with the sample D. It is therefore found that the high-k film according to the method of the present invention has highly excellent properties as compared to the high-k film according to the conventional method.

In each of the foregoing examples, the reducing gas atmosphere or the oxidizing gas atmosphere was employed as the gas atmosphere in the impurity removing step (heat treatment or anneal step), and the ammonia gas was used as the reducing gas atmosphere while the oxygen gas was used as the oxidizing gas atmosphere. However, the present invention is not limited to those gases and various kinds of gases can be employed. Namely, the reducing gas atmosphere in the impurity removing step may be formed by the use of a hydrogen gas or an inert gas, by the use of a mixed gas of the ammonia gas, the hydrogen gas or the inert gas, or by the use of plasma nitrogen, or may further be formed in a vacuum. Moreover, the oxidizing gas atmosphere in the impurity removing step may be formed by the use of a nitrous oxide (NO), a nitrogen monoxide (N₂O) gas, or an ozone gas, or by the use of a mixed gas obtained by appropriately mixing these gases, or further by the use of plasma oxygen.

Any of the foregoing embodiments was application of the method of the present invention to the method for forming the gate insulating film 4 of the MIS transistor 1, and the method for forming the gate insulating film 4 made of a high-k film on the Si substrate 2. However, the present invention is not limited to this method, and can be applied to formation of a capacitor insulating film of an MIM capacitor.

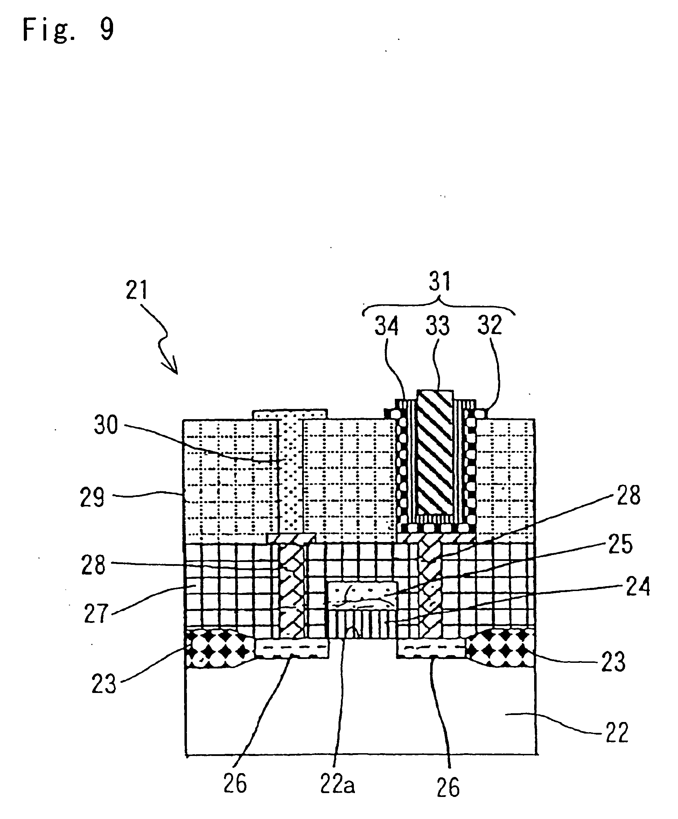

Fig. 9 is a view schematically showing a configuration of an MIM capacitor 21. In this figure, reference numeral 22 denotes a Si monocrystal substrate (hereinafter simply referred to as a Si substrate), and the resistivity thereof is from 0.01 to 15 Ω · cm, for example. Reference numeral 23 denotes an element isolation oxide film for isolating elements, which is formed by thermal oxidation of the Si substrate 22. Reference numeral 24 denotes a gate insulating film to be formed on the surface 22a of the Si substrate 22. The gate insulating film 24 is formed in the same manner as the formation of the gate insulating film 4 shown in the above-mentioned Fig. 1.

Reference numeral 25 denotes a gate electrode to be formed on the upper surface of the gate insulating film 24. For example, the gate electrode is made of a noble metal such as Pt (platinum) or a high melting point metal such as TiN or TaN, the noble metal and the high melting point metal not reacting with a polycrystal Si film, a polycrystal SiGe film or the gate insulating film 4. Reference numeral 26 denotes a channel region. P (phosphorous) or the like is injected into an n channel and B (boron) or the like is injected into a p channel, and those channels are heat treated at temperatures of 800 to 1,000 °C for 10 to 30 minutes to be activated. Reference numeral 27 denotes a first interlayer insulating film, which for example comprises SiO₂ or the like and formed by CVD method or the like. Reference numeral 28 denotes an extraction electrode of the channel 46. The extraction electrode 28 is formed in such a manner that a contact hole is formed in the first interlayer insulating film 27 by means of RIE (reactive ion etching) or the like, and a high melting point metal, such as Cu, Al, AlSi, Pt₂Si, TiN or TaN, is then provided in the contact hole.

Reference numeral 29 denotes a second interlayer insulating film to be formed on the upper surface of the first interlayer insulating film 27. The second interlayer insulating film 29 for example comprises SiO₂, and formed by CVD method or the like. Reference numeral 30 denotes an extraction electrode to be provided in the second interlayer insulating film 29 so as to be electrically connected with one of the extraction electrode 28 to be formed in the first interlayer insulating film 27, and is formed in the same manner as the formation of the extraction electrode 28.

Reference numeral 31 denotes a capacitor to be provided in the second interlayer insulating film 29 so as to be electrically connected with the other extraction electrode 28 to be formed in the first interlayer insulating film 27, and is constituted as described below. Namely, a contact hole is formed in the second interlayer insulating film 29, and a lower electrode 32, an upper electrode 33 and a capacitor insulating film 34 to be formed between the two electrodes 32 and 33 are formed in the contact hole, and constitute the capacitor 31. The lower electrode 32 comprises a noble metal such as Pt or a high melting point metal such as TiN or TaN. The upper electrode 33 comprises a noble metal such as Cu, Al or Pt or a high melting point metal such as TiN or TaN. Either the electrode 32 or 33 is constituted of a material that does not react with the capacitor insulating film 34. The capacitor insulating film 34 is then formed using a high-k film on the upper surface of the lower electrode 32. It is to be noted that patterning is performed for example by means of the photolithography technique.

In order to test the performance of the capacitor insulating film 34, for example, a SiO₂ film having a thickness of 200 nm was formed on the Si substrate, and on the upper surface thereof, a Pt film having a thickness of about 100 nm was formed, to give a lower capacity electrode. Subsequently, samples A to C were formed on the upper surface of the lower capacity electrode made of the Pt film, by the method shown in Fig. 8. As a comparative example, a high-k film having a thickness of 3 nm was formed in a single process by the conventional method, and referred to as a sample D. A TiN film was then formed as an upper electrode. The electric characteristics of the capacitor insulating film were evaluated, to obtain the results shown in Table 3.

**[Table 3]**

| | dielectric breakdown voltage (MV/cm) |
|---|---|
| A | 8 . 0 . ∼ 1 0 |
| B | 8.4 ∼ 1 0 |
| C | 8. 6 ∼ 1 2 |
| D | 3. 5 ∼ 7. 4 |

It is found from Table 3 above that the dielectric breakdown voltage of each of the samples A to C according to the method of the present invention is higher than that of the sample D according to the conventional method, and hence the samples A to C are films of good quality. This is because, as apparent from Table 1, each of the samples A to C is a dense film of good quality having a large film density and containing a very small amount of impurities as compared with the sample D. It is therefore found that the high-k film according to the method of the present invention also has highly excellent properties as the capacitor insulating film 34.

It is to be noted that, although the Si substrate was used as the substrate on which the high-k film was to be formed in the above-mentioned embodiments, the substrate is not limited thereto, and a GaAs compound semiconductor substrate or a SOI (Silicon On Insulator) substrate may be used as the substrate.

As thus described above, according to the present invention, it is possible to form a gate insulating film made of a high-k film containing few impurities, so as to reduce flat band shift and an interface fixed charge due to the impurities, resulting in production of a high-quality MIS transistor. It is also possible to form a capacitor insulating film made of a high-k film containing few impurities, so as to prevent a decrease in dielectric break down voltage due to the impurities, resulting in production of a high-quality MIM capacitor.

## Claims

1. A method for forming an insulating film in a semiconductor device **characterized in that** a step of forming an insulating film so as to have a thickness in the range of 0.3 to 2 nm by ALD and a step of removing impurities contained in the insulating film are alternately repeated a plurality of times, to form an insulating film having a prescribed thickness, and that said step of removing impurities comprises heat treatment at 500°C or higher.

2. The method for forming an insulating film in a semiconductor device as claimed 1, therein the step of removing impurities is performed in a reducing gas atmosphere or an oxidizing gas atmosphere.

3. The method for forming an insulating film in a semiconductor device as claimed 1, therein the step of removing impurities is performed in a reducing gas atmosphere combined with an oxidizing gas atmosphere.

4. The method for forming an insulating film in a semiconductor device as claimed 2 or 3, therein the reducing atmosphere in the step of removing impurities is formed of any of single gases of an ammonia gas, a hydrogen gas and an inert gas, a mixed gas of these gases or plasma nitrogen, or formed in a vacuum.

5. The method for forming an insulating film in a semiconductor device as claimed 2 or 3, therein the oxidizing gas atmosphere in the step of removing impurities is formed of any of single gases of an oxygen gas, a nitrogen monoxide gas, a nitrous oxide gas and an ozone gas, a mixed gas of these gases or plasma oxygen.

## Patentansprüche

1. Verfahren zur Bildung einer Isolierschicht in einem Halbleiterbauelement, **dadurch gekennzeichnet, dass** zur Bildung einer Isolierschicht mit vorgegebener Dicke ein Schritt zum Bilden einer Isolierschicht durch Atomlagenabscheidung ALD (engl. atomic layer deposition), in einer Weise, dass sie eine Dicke im Bereich von 0,3 bis 2 mm aufweist, und ein Schritt zum Entfernen von in der Isolierschicht enthaltenen Verunreinigungen abwechselnd mehrmals wiederholt werden, und dadurch, dass der Schritt zum Entfernen von Verunreinigungen eine Wärmebehandlung bei 500 °C oder darüber umfasst.

2. Verfahren zur Bildung einer Isolierschicht in einem Halbleiterbauelement nach Anspruch 1, wobei der Schritt zum Entfernen von Verunreinigungen in einer reduzierenden Gasatmosphäre oder in einer oxidierenden Gasatmosphäre durchgeführt wird.

3. Verfahren zur Bildung einer Isolierschicht in einem Halbleiterbauelement nach Anspruch 1, wobei der Schritt zum Entfernen von Verunreinigungen in einer reduzierenden Gasatmosphäre in Kombination mit einer oxidierenden Gasatmosphäre durchgeführt wird.

4. Verfahren zur Bildung einer Isolierschicht in einem Halbleiterbauelement nach Anspruch 2 oder 3, wobei die reduzierende Atmosphäre in dem Schritt zum Entfernen von Verunreinigungen aus einem einzigen Gas aus der Gruppe gasförmiges Ammoniak, Wasserstoffgas und Inertgas, einem Gasgemisch aus diesen Gasen oder Stickstoffplasma gebildet wird, oder in Vakuum gebildet wird.

5. Verfahren zur Bildung einer Isolierschicht in einem Halbleiterbauelement nach Anspruch 2 oder 3, wobei die oxidierende Atmosphäre in dem Schritt zum Entfernen von Verunreinigungen aus einem einzigen Gas aus der Gruppe Sauerstoffgas, Stickstoffmonoxidgas, Distickstoffmonoxidgas und Ozongas, einem Gasgemisch aus diesen Gasen oder Sauerstoffplasma gebildet wird.

## Revendications

1. Procédé de formation d'un film isolant dans un dispositif semi-conducteur, **caractérisé en ce qu'**une étape de formation d'un film isolant pour qu'il ait une épaisseur dans la plage de 0,3 à 2 nm par ALD et une étape pour retirer les impuretés se trouvant dans le film isolant sont répétées alternativement plusieurs fois, pour former un film isolant d'une épaisseur prescrite, et **en ce que** ladite étape de retrait des impuretés comprend un traitement thermique à 500°C ou à une température plus élevée.

2. Procédé de formation d'un film isolant dans un dispositif semi-conducteur selon la revendication 1, où l'étape de retrait des impuretés est exécutée dans une atmosphère gazeuse réductrice ou dans une atmosphère gazeuse oxydante.

3. Procédé de formation d'un film isolant dans un dispositif semi-conducteur selon la revendication 1, où l'étape de retrait des impuretés est exécutée dans une atmosphère gazeuse réductrice combinée avec une atmosphère gazeuse oxydante.

4. Procédé pour former un film isolant dans un dispositif semi-conducteur selon la revendication 2 ou 3, où l'atmosphère réductrice dans l'étape de retrait des impuretés est formée par l'un quelconque des gaz uniques d'un gaz d'ammoniac, d'un gaz d'hydrogène et d'un gaz inerte, d'un gaz mélangé de ces gaz ou de plasma d'azote ou est réalisée dans un vide.

5. Procédé de formation d'un film isolant dans un dispositif semi-conducteur selon la revendication 2 ou 3, où l'atmosphère gazeuse oxydante à l'étape du retrait des impuretés est formée par l'un quelconque des gaz uniques d'un gaz d'oxygène, d'un gaz de monoxyde d'azote, d'un gaz d'oxyde nitreux et d'un gaz d'ozone, d'un gaz mélangé de ces gaz ou d'un oxygène de plasma.
